Europäisches Patentamt

European Patent Office

Office européen des brevets

(19)

(11) Publication number: **0 141 892**
A2

(12)

# EUROPEAN PATENT APPLICATION

(21) Application number: **84100973.1**

(22) Date of filing: **01.02.84**

(51) Int. Cl.⁴: **H 01 L 29/06, H 01 L 29/08**

(30) Priority: **15.11.83 US 551824**

(43) Date of publication of application: **22.05.85**
**Bulletin 85/21**

(84) Designated Contracting States: **AT BE CH DE FR GB IT LI LU NL SE**

(71) Applicant: **Refining Energy Services, Inc., Suite 404 One Elm Place, 11107 Wurzbach San Antonio Texas 78239 (US)**

(72) Inventor: **Zhu, En Jun, Dr., 3200 Finfeather Road, 267 Bryan, Texas 77801 (US)**

(74) Representative: **Goddar, Heinz J., Dr. et al, FORRESTER & BOEHMERT Widenmayerstrasse 4/I, D-8000 München 22 (DE)**

(54) **Low surface recombination effect semi-conductor device.**

(57) A semi-conductor device having proper means for concentrating current injection in the central part of the emitter and eliminating the surface recombination effect is shown and described. In one apparatus there is a contact located in the central region of the emitter and a second contact located in the peripheral region of the emitter to provide a bias voltage between the central region and the peripheral region of the emitter. In another apparatus, current injection reduction at the periphery is produced by the difference in diffusion potentials of the materials chosen for the emitter and base components of the semi-conductor device.

0141892

# LOW SURFACE RECOMBINATION EFFECT SEMI-CONDUCTOR DEVICE

## BACKGROUND OF THE INVENTION

### FIELD OF THE INVENTION

This invention relates to a fundamental technique for reducing the surface recombination effect at an emitter-base junction in a semiconductor device. The surface recombination at the emitter-base junction of particular importance in the construction and operation of super gain transistors.

### DESCRIPTION OF THE PRIOR ART

The problem of emitter-base junction surface recombination effects has long been recognized by those working in the field of super gain transistors. The surface recombination effect in super gain transistors produces a substantial decrease in the gain of the transistor when low collector currents are present. This caused by the effect of the surface recombination on the base current. The base current rises and the gain is consequently decreased.

In the prior art there are two known techniques which have been used to decrease the surface combination effect in super gain transistors. These are the use of a controlled environment in the junction region, and the use of a separate gate in the region of the surface of the emitter-base junction.

An article entitled "The Influence of Fixed Interface Charges on the Current-Gain Falloff Planar n-p-n Transistors" by Wolfgang M. Werner disclosed control of the surface charge by fabricating and maintaining a clean environment. It was found that the lowest possible fixed interface charge was obtainable by the use of diffusion and oxidation process carried out in and MOS furnace.

It is also known that certain impurities around the junction may be limited by controlling the environment around the device. This may be by elimination of its exposure to the environment. The environmental effects themselves cause surface recombination. The use of silicone nitrate ($Si_3N_4$) to protect the surface is known. This technique is currently used in super gain transistor technology. The present results achievable in super gain transistors would be impossible without the use of this technique.

In another attempt to control surface recombination effects in super gain transistors, it has been found that an additional gate applied at the junction of the emitter and base may be used to reduce the surface charge. This work is described in "Influence of Surface Conditions on Silicone Planar Transistor Current Gain" by V. G. K. Reddi SOLID STATE ELECTRONICS, Pergamon Press 1967, Vol. 10, pp. 305-334 and in an article entitled "Effect of Surface Recombination and Channel on P-N Junction and Transistor Characteristics" by Chih-Tang Sah, published in IRE TRANSACTIONS, ON ELECTRON DEVICES, Vol. Ed. 9, Page 94-108, January 1962. In these articles, it is disclosed that surface recombination may be controlled by the use of a gate electrode and material oxide located in the region of the emitter-base junction. The gate is used to control the surface recombination by the action of the gate bias which repels charges at the junction. This technique however has only been successful in laboratory experimentation. It has not been possible to completely control the surface recombination with charge repulsion because there must also be given consideration to the surface state level. This solution so far has not been found to be practical, and has not been used in production of commercial devices.

## BRIEF SUMMARY OF THE INVENTION

This invention is a semi-conductor device which provides high gain and low surface recombination effect at the emitter-base junction surface region by concentrating the current injection in the central part

0141892

of the emitter far away from the peripheral region. In one embodiment of this invention a central electrode is provided on the emitter, and a peripheral electrode or emitter isolator electrode is provided around the periphery. A bias voltage is used at the peripheral electrode to reduce the current injection. In another embodiment, the reduction of the current injection at the periphery is produced by the inherent difference in diffusion potentials of the materials chosen for the emitter and base in a heterojunction transistor. In operation, both embodiments utilize a high resistivity emitter material.

## DESCRIPTION OF THE DRAWINGS

Figure 1 shows a concentric injection emitter semi-conductor device including bias voltages and a bias source.

Figure 2 shows a top view of the device of Figure 1 wherein the device is circular in design.

Figure 3 shows an enlarged view of the emitter and base regions of the device of Figure 1 including current flows.

Figure 4 shows another embodiment of a concentric injection emitter transistor in accordance with this invention wherein the contacts are all located at one surface.

Figure 5 shows the voltage distributions across the concentric injection emitter device of Figures 1, 3, and 4.

Figure 6 shows the relationship of the injection current to the voltage at the radius, and hence the concentration of injection current beneath the emitter.

Figure 7 shows a graph of the gain achievable with conventional super gain transistors, and that obtainable with the concentric injection emitter design of this device.

Figure 8 shows the relationship of the injection current to the voltage at the emitter base junction.

Figure 9a shows a three layer emitter base collective material prior to the step of electron implantation.

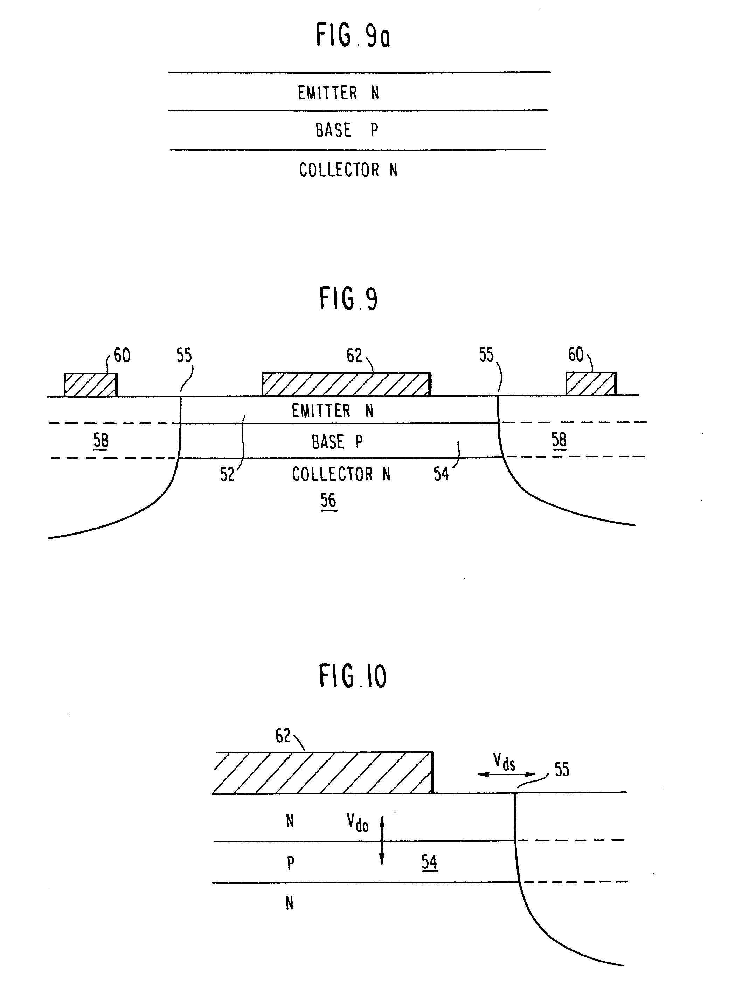

Figure 9 shows a device in accordance with this invention which is constructed by the use of ion implantation and which uses the diffusion potentials of the material to provide a bias between the central portion of the emitter and the peripheral portion of the emitter.

Figure 10 shows an enlarged view of the emitter base surface junction of the device of Figure 9.

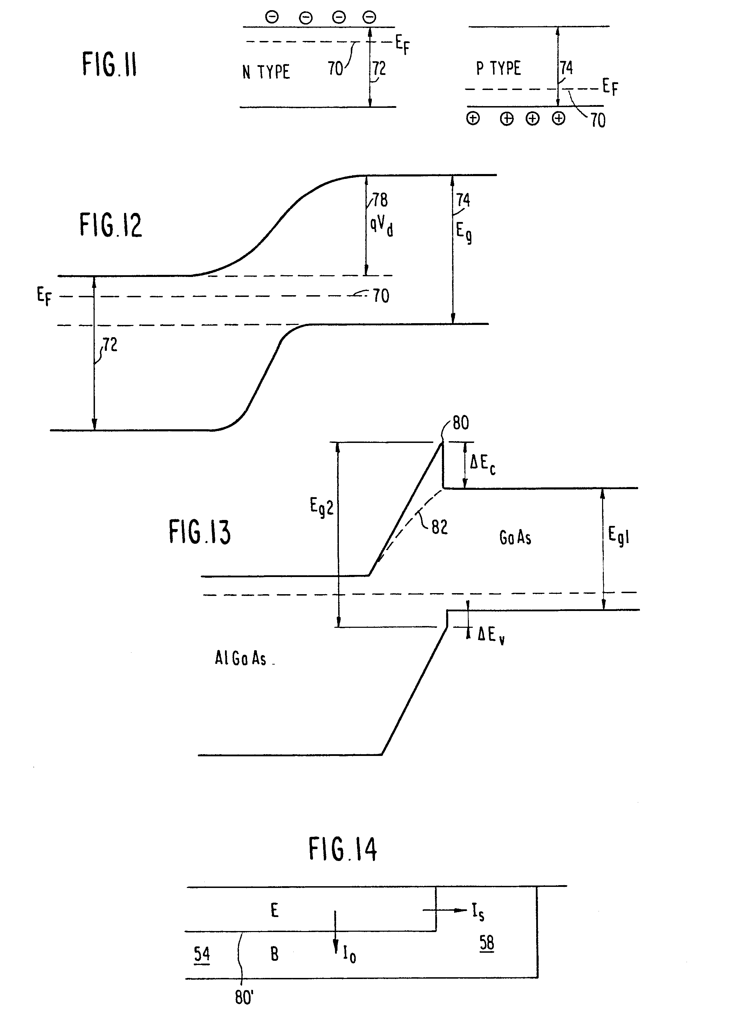

Figure 11 shows the energy band of typical materials and the energy band gap when the materials are placed together.

Figure 12 shows the relationship of $E_g$ to $V_d$ when the Fermi levels are considered.

Figure 13 shows a device constructed which includes an energy barrier 80, or one wherein it is eliminated as indicated by 82.

Figure 14 shows an enlarged view of the currents associated with the emitter base junction of Figure 10.

## DETAILED DESCRIPTION OF THE PREFERRED EMBODIMENTS

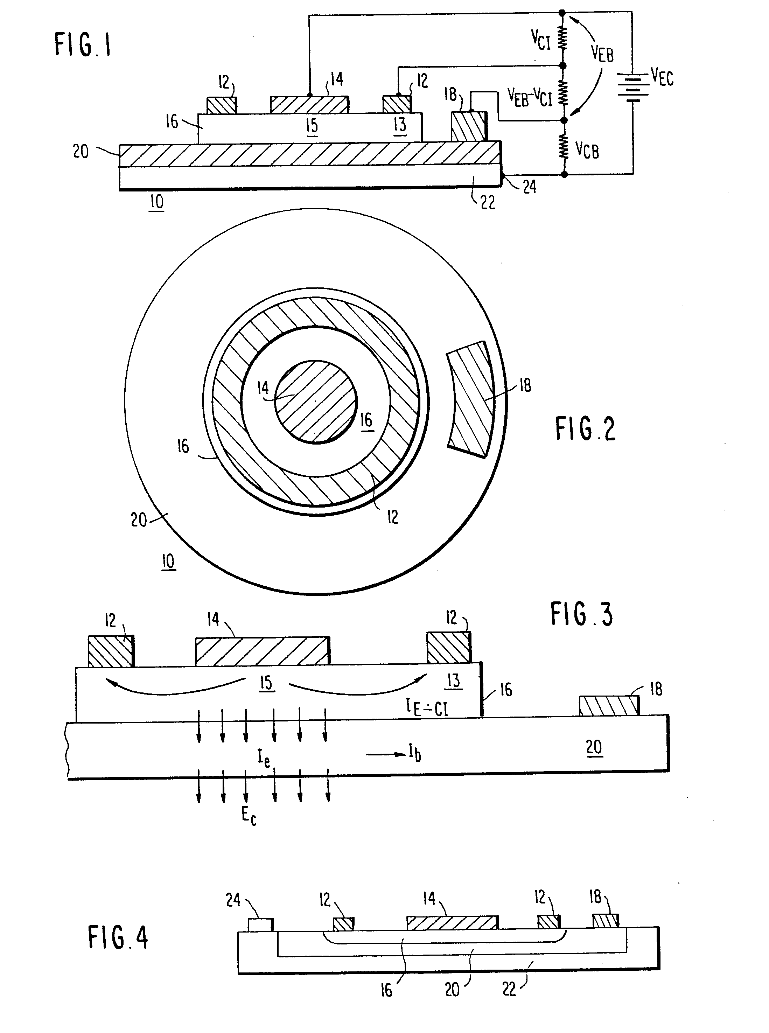

The principals of the function and operation of this invention are best understood by reference to the embodiment wherein there is a contact located in the peripheral region of the emitter and a bias is applied between the peripheral contact and the center emitter contact. By reference to Figure 1 there is shown a cross-sectional view of a semi-conductor device of this type. The device 10 of Figure 1 is a silicone type transistor wherein the emitter region 16 is composed of polycrystalline or amorphous silicone. The polycrystalline or amorphous material is used so that there will be a high resistivity between the central electrode 14 and the concentric injection electrode 16. This structure may be termed a concentric injection high-resistivity emitter. The base 20 may be of any configuration as may be the electrode 18. The collector 22 also may be of any conventional design. In Figure 1 there is also shown schematically the application of the bias voltages to the concentric injection high resistivity emitter transistor structure. The voltage $V_{EC}$ is a conventional emitter collector bias voltage as are the voltages $V_{CB}$ (collector base) and $V_{EB}$ (emitter base). In this concentric injection high resistivity emitter there is supplied another voltage, $V_{CI}$ which is the voltage between the central contact region 15 and the peripheral region 13. This voltage is applied between a second peripheral contact 12 and the central contact 14. There is no need to isolate the power supply $V_{CI}$ from the conventional power supply $V_{EC}$, $V_{EB}$, and $V_{CB}$. In Figure 2 there is shown a top view of the transistor device of Figure 1. In this embodiment, the physical shape of the emitter electrode, the emitter 16, the concentric emitter electrode 12 and the base 20 have all been chosen to be circular in shape. In this manner, it is relatively straight forward to calculate the resistance between the electrode 14 and the electrode 12 as in order to determine the current flow produced by the bias voltage $V_{CI}$ the base contact electrode 18 is depicted on one side of the device for convenience. Any other configuration such as square, rectangular, or other configuration may be used as long as there is a central contact region, a peripheral region, and a bias voltage between the two.

In a typical embodiment, there may be a separation between the central contact, and the peripheral region contact of 3 to 5 microns. The thickness of a typical emitter may be in the order of 0.3 to 0.5 microns.

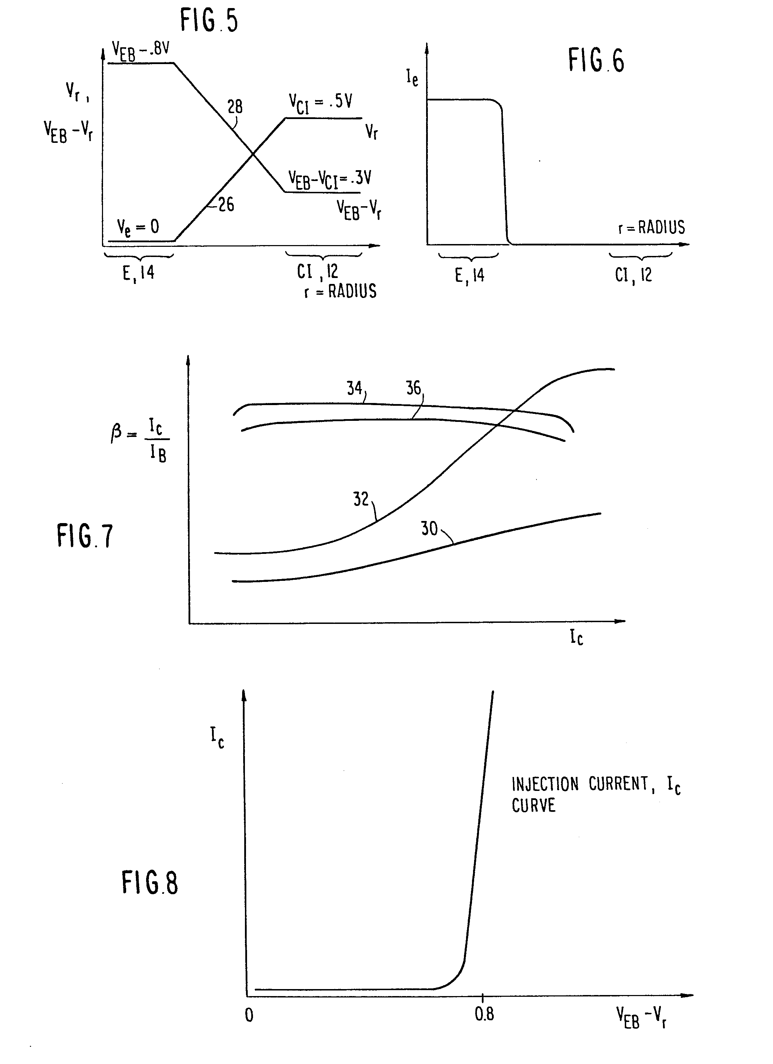

The physical configuration of the device incorporating a central contact and a contact in the peripheral region may be of any suitable design. Figure 4 shows a design wherein all of the contacts are located at one surface of the device. Here, the central contact is 14, the peripheral contact is 12, the base contact is 18, and the collector contact is 24. The regions 16, 20, and 22 respectfully represent the emitter base and collector regions of the device. Here again the emitter is preferably a polycrystalline silicone, or amorphous silicone. The thickness of the emitter 16 may be on the order of 0.3 to 0.5 microns and the distance between the contact 14 and the contact 12 may be in the order of 3 to 5 microns. In this configuration using the materials disclosed, the resistance between the electrode 14 and the electrode 12 across the emitter is 1000 ohms or greater. Values in the order of 100kohms may be used, with the consequent decrease in heat dissipation due to the bias current through the emitter region. Typical materials to be used for the emitter region 16 may have resistivities in the order of 0.1 to 10 ohm-cm.

In Figure 3 there is shown an enlarged view of the emitter base region of the device of Figure 1. Here, in the emitter region, there is shown a current $I_{E-CI}$ which is the current flowing in the emitter region due to the bias between the central contact 14, and the circular contact 12 as it moves through the emitter region. There is also shown the injection current from the emitter to the base as $I_e$. In Figure 3, the effects of surface recombination at the surface junction of the emitter 16 and the base 20 is not shown, because this effect is essentially eliminated by the bias between the central region 15 and the peripheral emitter region 13.

In Figure 5 there is shown the potential distributions across the concentric injection high resistivity emitter device of Figure 1 or Figure 4 as measured from the center of the electrode 14 outward to the region of the concentric emitter 12. The voltages are a function of the radius r. For purposes of illustration, the distance representing the radius of the emitter electrode 14 as shown at the bottom as E, 14 and the region representing the concentric injection electrode 12 is shown on the right side as CI. Here, $V_{CI}$, the bias between the central emitter and the concentric electrode located in the region of the emitter periphery is chosen to be .5 volts. In Figure 5, the level of point .5 volts is shown on the right hand side above that area of the radius where the electrode 12 is located. The curve $V_r$ begins at zero because this is the voltage that the center electrode of the emitter 14 is placed at by virtue of the bias voltage $V_{CI}$. The voltage gradient due to the bias is shown as the slope 26 extending from the central emitter region the peripheral region of electrode contact 12. Similarly $V_{EB}$ (the voltage between the base and the emitter has been chosen to be 0.8 volts. This voltage when viewed across the E-B junction like the voltage $V_r$ is a gradient between the emitter electrode 14 and the concentric peripheral electrode 12. This gradient is shown as reference numeral 28. The voltage across the junction at the concentric peripheral electrode 12 is $V_{EB}-V_{CI}$ which in the case is shown in Figure 5 becomes equal to 0.3 volts. This is also shown as the voltage from the base electrode 18 to the electrode 12 in Figure 1.

Figure 6 shows the distribution of the injection current $I_c=I_e$ as it appears along the region of contact between the emitter 16 and the base 20 as a function of the radius and on the same scale as that depicted and discussed with respect to Figure 5. Here, the rapid fall off of the injection current $I_c$ to essentially 0 is shown to occur at the point where the central electrode 14 ends along the radius. This phenomenon is produced by the voltage radius curve shown in Figure 5, and particularly the gradient 28 which shows $V_{EB}$ dropping below .8 volts as the voltage $V_r$ is subtraced from it. It should be noted that the gradient of the voltage $V_r$ is produced by the resistance of the emitter 16 between electrodes 12 and 14 and the emitter bias current $I_{CI}$. It is for this reason that it is necessary to have a current flowing in the region of emitter. Also in Figure 5, the curve $V_{EB} - V_r$ is the gradient of the voltage between the emitter and base along the line where they are joined together and in the region between the electrodes 14 and 12.

In Figure 8 there is shown a graph of the injection current $I_c$ as a function of the voltage between the emitter and base. The injection current $I_c$ remains essentially at zero until the emitter base bias reaches the predetermined level of 0.8 volts. For this reason, the injection current across the region of the emitter between the electrodes 14 and 12 remains essentially 0. Obviously, the injection current beneath the electrode 12 (at the periphery) will be zero. In this manner, the injection current is concentrated immediately beneath the electrode 14, the center electrode. Stated another way, there is no significant injection current in the region of the emitter-base surface junction and for this reason, recombination effects are essentially eliminated.

In the operation of the device shown in Figure 1-4, there is a dissipation of energy due to the IR loses in the emitter which are produced by the current $I_E - _{CI}$. This dissipation can be reduced considerably by increasing the resistance of the emitter material as long as there is a current flowing in the emitter, the voltage gradient shown in Figure 5 will exist, and hence the injection current will be concentrated immediately beneath the center electrode 14 on the emitter 16 or in the region 15 as shown in Figures 1 and 3.

It is also known that the injection current density $I_e$ may be represented as follows:

Equation 1

$$I_e \propto \exp\left[\frac{q}{KT}(V_{eb} - V_r)\right]$$

In the above equation where

Equation 2

$$\frac{KT}{q} = 0.026V$$

when $V_{EB} - V_r$ decrease a value of 0.026V, the injection current density will decrease to $\frac{i}{e}$ of its original value,

This relationship confirms the fact that the injection current must be concentrated just beneath or very close to the center emitter 14 of Figures 1, 3, and 4. This relationship is also confirmed by the curve of Figure 7 which shows the injection current $I_c$ as a function of $V_{EB} - V_r$.

The curves of Figure 7 show the performance of transistors incorporating isolator bias with concentric injection electrodes in curves 34 and 36. Similar transistors merely relying upon conventional methods to reduce surface recombination at the emitter base junction region are shown as 32 and 30. It should be noted that in Figure 32 where the gain is high, it falls more rapidly when $I_c$ is decreased.

By using the principal of an emitter isolator bias the recombination current is reduced by the bias source and the base current source therefore has less recombination requirements. When this demand on the base current is reduced, the gain remains higher as $I_c$ us reduced.

The bias $V_{CI}$ reduces recombination and is solely a function of the resistance between the central emitter and isolator electrodes in the embodiments shown in Figures 1, 3, and 4. When the resistance between the emitter and isolator electrodes is high, the current becomes very small, so that the dissipation due to the bias current is also substantially reduced.

The technique of providing a bias voltage connected to a contact located in the central contact region of a device and a contact in the peripheral region of the device emitter is specially effective for bipolar transistors where the surface effects have been found to be a very serious problem. Such bipolar transistors are constructed of materials taken from Group III and Group IV of the periodic table and are identified in Table 1 herein below.

<u>TABLE I</u>

| III | IV | V |
|-----|-----|-----|
| B | C | N |
| AL | SL | P |
| Ga | Ge | As |
| In | Tn | Sb |

It should also be noted that although polycrystalline or amorphous silicone has been used in the preferred embodiment of Figures 1, 3, and 4, that this type of transistor is of the bipolar type. In the preferred embodiments, polycrystalline silicone is used for a silicone transistor. Another combination of materials is aluminum galium arsenide (AlGaAs) used as a heterojunction emitter in a galium arsenide (GaAs) transistor. Other high resistivity wide gap configured emitters may be used for other bipolar transistor configurations and these may include an indium phosphide ($I_nP$) emitter with a galium indium arsenide base (GaInAs), and aluminum indium arsenide (AlInAs) emitter with a galium indium arsenide (GaInAs) base. As a general requirement considering physical size of the emitter, the emitter material should have a resistance in the range of .1 to 10 ohms per cm.

In Figure 9 there is shown a semi-conductor device in the form of a transistor which incorporates the principals of reducing current injection at the periphery region, but without the use of a separate bias voltage such as $V_{CI}$ as depicted in Figure 1. In this embodiment, the emitter isolator bias electrode 12 of Figure 1 is also eliminated.

The device of Figure 9 is created by ion implantation of the three layers, the emitter base and collector as depicted in Figure 9a. The ion implanted area 58 provides for an extension of the base to the surface and for placement of the contact 60 for the base electrode. Through ion implantation, the material on each side of the emitter base junction at the surface, 55 remains the same.

In the structure illustrated of Figure 9, ion implantation is used to provide the emitter-base junction at the emitter periphery, 55. The region 58 represents the area of ion implantation.

Typical materials for this device are:

<div align="center">TABLE 2</div>

| | | |
|---|---|---|
| 52 (Emitter) | AlGaAs | InP |
| 54 (Base) | GaAs | GaInAs |
| 56 (Ccollector) | GaAs | GaInAs |

The bottom of the emitter layer 52 acts as a central emitter in a manner similar to the area under the central contact in Figures 1, 3, and 5. The device is a heterojunction transistor wherein the P-N junction diffusion potential $V_{do}$ (Fig. 10) is determined by the band gap of the base material 54. However, at the emitter periphery on the surface 55, both sides of the junction 55 are composed of the emitter material, due to the ion implantation in the region 58. In the region of the emitter base surface contact, the diffusion potential $V_{ds}$ is determined by the band gap of the emitter 52 material.

In this embodiment, the voltage across the emitter base junction is the same at all points. The threshold voltage is dependant upon $V_d$ (diffusion potential) which is different from the surface region to the central region.

The band gap of the emitter material is chosen so that it is greater than the band gap of the base material. Therefore, the difference in P-N junction diffusion potentials $V_{ds} - V_{do}$ is determined by the difference of the band gap between the emitter and base material and defined as follows:

EQUATION 3

$$V_{ds} - V_{do} \approx \frac{1}{q} \Delta E_g$$

This equation is valid if there is no "conductive band discontinuity".

Figure 11 represents the band gap of a typical material in its n type and its p type. For the n type material, reference 72 indicates the energy band gap while in the p type reference 74 represents the energy band gap. When the two materials are placed together, a diffusion potential 78 occurs. In Figure 12 there is set forth the energy levels as they occur when materials are placed together. Since the Fermi level 70 in a typical material is in the order of 0.05ev, near the band edge and the energy gap $E_g$ is much higher, $V_d$ approximates $E_g$, see equation 4 below.

EQUATION 4

$$V_d \approx \frac{1}{q} E_g$$

Typical energy band gaps are silicone 1.2ev. galium arsenide 1.35ev, and aluminum .3 galium .7 arsenide 1.7ev. Since the energy gaps are the order of ten times or greater than the Fermi levels, it can be seen that the approximation of equation 4 can be used.

Referring now to Figure 13 there is shown the relationship of the energy gaps of two materials such as galium arsenide (GaAs) and aluminum galium arsenide (AlGaAs) when joined together in a heterojunction semiconductor device. In a heterojunction, the materials are different, and not just n and p types of the same materials. In Figure 13 the difference in energy gap between the first and second materials may be represented by equation 5 wherein the difference in the energy gaps is equal to the difference in the energy in the conductive band pulse the difference energy in the valence band.

## EQUATION 5

$$\Delta E_g = \Delta E_c + \Delta E_v$$

Also, the difference in energy gap is represented as the difference of the energy band gap between the second material and the first material. The follow equations shows this relationship.

## EQUATION 6

$$\Delta E_g = E_{g2} - E_{g1}$$

Referring again to Figure 13, there is shown at the top the energy barrier 80 which is the same as $\Delta E_c$ of the conductive band discontinuity. A device of this invention may be made with an abrupt junction wherein the energy barrier is present (80), or where the energy barrier is eliminated when a graded junction is produced as will be explained hereinafter (82).

Figure 14, shows an enlarged view of an ion implanted base region 58. $I_o$ indicates the injection

current from the emitter to base, and $I_s$ indicates the current flowing from the emitter to base at the surface region where the emitter and base are joined. Reference numeral 80' indicates the region of $I_o$ which is also the area where the bearer 80 occurs.

The ratio of $I_o$ to $I_s$ is given by the following equation when no energy barrier is present at the interface.

EQUATION 7

$$\frac{I_o}{I_s} \; \alpha \; \exp \left[ \frac{q}{KT} (V_{ds} - V_{do}) \right]$$

Earlier in equation 3 it was noted that $V_{ds}$ and $V_{do}$ are related to $\Delta E_g$. Therefore this equation becomes:

Equation 8

$$\frac{I_o}{I_s} \; \alpha \; \exp \left[ \frac{q}{KT} \; \Delta E_g \right]$$

Equation 8 thus represents the current ratios where there is no energy barrier present in the heterojunction device.

Where there is an energy barrier as depicted by reference numerals 80 and 80' the relationship is as follows:

Equation 9

$$\frac{I_o}{I_s} \alpha \; \exp \frac{q}{KT} \; [\Delta E_g - \Delta E_c]$$

The relationship between $\Delta E_g$, $\Delta E_c$, and $\Delta E_v$ has however been established by equation 5 above, therefore, the critical determinate in construction of a device wherein an energy barrier is present is given by the following formula:

<center>Equation 10</center>

$$\Delta E_v = \Delta E_g - \Delta E_c$$

By this step, it is determined that $\Delta E_v$, the valence band discontinuity between the two materials is the critical factor in choice of materials for a device wherein an energy barrier is present.

Materials which may be used for the structure having an energy barrier or an abrupt structure may be indium phosphide (InP) as the emitter material and galium indium arsenide (GaInAs) as the base material. With this choice of materials, $\Delta E_v$ becomes important for deciding which materials are to be used in the heterojunction device of this type. A choice for this type of structure may be indium phosphide (InP) as the emitter, and galium indium arsenide (GaInAs) as the base.

The material which may be used for the graded structure is galium arsenide and aluminum galium arsenide. In this choice of materials, the emitter will be of aluminum galium arsenide (AlGaAs) and graded while the base will be of pure galium arsenide (GaAs). This choice of material for a graded structure is possible because the lattice match between galium arsenide and aluminum galium arsenide covers a wide range. The gradient of aluminum concentration in the emitter will be from $Al_{0.6}$, $Ga_{0.4}$, as down to $Al_0$, $Ga_{10}$, at the region where the base galium arsenide is located. The energy barrier at the emitter base interface 80' as depicted in Figure 13 will be reduced to zero because of the graded structure possible with aluminum galium arsenide. It is for this reason that the ratio $I_o$ to $I_s$ can be set forth as in equation 8 above.

Photo transistors may be constructed which incorporate a means for providing a larger diffusion potential at the junction of the emitter base surface area. In the use as a photo transistor, means only need be provided for emitting light into the base region to provide signal input for base control. The wave length to which the base material is sensitive is determined by the choice of materials used in the base. Where aluminum galium arsenide and galium arsenide are used for the emitter and base respectfully, the base material will be sensitive to the light having a wave length of 8000Å. Where indium phosphide and galium indium arsenide are used, the wave length will be in the order of 1.5 microns.

While applicant has described what at present are believed to be the preferred embodiments of this invention, it will be obvious to those skilled in the art various changes and modifications may be made therein without departing from the invention. It is intended that the dependent claims shall cover all such changes and modifications as fall within the true scope and spirit of this invention.

IN THE CLAIMS:

1.   A semiconductor device having high gain and low surface recombination effect at the emitter base junction region comprising in combination:

a single emitter having a central contact region and a peripheral region;

a base region, having a surface portion which engages said emitter peripheral region; and

means for concentrating the emitter injection current in the emitter central contact region.

2.   The apparatus of claim 1 wherein said means for concentrating the emitter injection current comprises a source of bias voltage connected to a contact located in said central contact region and connected to a contact in the peripheral region.

3.   The apparatus of claim 1 wherein said means for concentrating the emitter injection current in the emitter central contact region comprises the difference in diffusion potentials of the materials chosen for said emitter and base.

4.   The apparatus of claim 2, wherein said contact in the peripheral region is completely around said periphery.

5.   The apparatus of claim 4, wherein said central contact region is separated from said peripheral region by a distance sufficient to provide a high resistance between said central contact region and said peripheral contact.

6.   The apparatus of claim 1 wherein said emitter material is a material having a high resistivity.

7.   The apparatus of claim 1 wherein said emitter material is amorphous silicon material having a high resistivity.

8.   The apparatus of claim 7 wherein said base material is a silicon material.

9.   The apparatus of claim 5 wherein said contact located in the central region is circular in shape.

10. The apparatus of claim 5 wherein is peripheral region contact is circular in shape.

11. The apparatus of claim 9 wherein said peripheral region contact is circular in shape.

12. The apparatus in accordance with claim 6 wherein said high resistance is 1000 ohms or more.

13. The apparatus of claim 1 wherein said device is sensitive to light striking its base region.

14. The apparatus of claim 2 wherein the entire dissipation of energy from said bias source is within said emitter region.

15. The apparatus of claim 2 wherein said emitter material is aluminum galium arsenide.

16. The apparatus of claim 2 wherein said base is galium arsenide.

17. The apparatus of claim 2 wherein said emitter is indium phosphate.

18. The apparatus of claim 2 wherein said base is galium indium arsenide.

19. The apparatus of claim 3, wherein said device is a heterojunction transistor.

20. The apparatus of claim 2, wherein said device is a bipolar transistor.

21. The apparatus of claim 3, wherein the material in the region where surface recombination will occur is the material of the emitter which has been subjected to ion implantation.

22. The apparatus of claim 3, wherein the emitter region and the ion implanted region of the base is constructed of aluminum galium arsenide which is graduated in concentration from .01 to .6.

23. The apparatus of claim 22 wherein there is no electron injection barrier at the heterojunction interface caused by a conductive band discontinuity.

24. The apparatus of claim 22, wherein there is no electron injection barrier at the heterojunction interface when aluminum galium arsenide is used and which is graduated from 0 to .6 at the interface.

25. The apparatus of claim 3, wherein valence band discontinuity ΔEv of the heterojunction is large.

26. The apparatus of claim 3, wherein an abrupt junction is adopted and the materials chosen for the emitter and base provide an energy barrier between the emitter and base regions.

27. The apparatus of claim 3, wherein the emitter is a graded material which eliminates the energy barrier otherwise produced between the emitter and base regions.

28. The apparatus of claim 28, wherein the emitter material is InP.

29. The apparatus of claim 28 wherein the base material is GaInAs.

30. A heterojunction semi-conductor device in accordance with claim 3, wherein the ratio of the current flowing from the emitter base to the current associated with the surface effect at the emitter base junction is a function of $\Delta E_g$, the difference in band-gap of the materials chosen for the emitter and base is in accordance with the following formula:

$$\frac{I_o}{I_s} \alpha \exp \left[\frac{q}{KT} \Delta E_g\right]$$

31. A heterojunction semi-conductor device in accordance with claim 22, wherein the ratio of the current flowing from the emitter base to the current associated with the surface effect at the emitter base junction is a function of $\Delta E_g$, the difference in band-gap of the materials chosen for the emitter and base is in accordance with the following formula:

$$\frac{I_o}{I_s} \alpha \ \exp \left[\frac{q}{KT} \Delta E_g\right]$$

32. A heterojunction semi-conductor device in accordance with claim 3, wherein the ratio of the current flowing from the emitter base to the current associated with the surface effect at the emitter base junction is a function of $\Delta E_g$, the difference in band-gap of the materials chosen for the emitter and base is in accordance with the following formula:

$$\frac{I_o}{I_s} \alpha \ \exp \left[\frac{q}{KT} \left[\Delta E_g - \Delta E_c\right]\right]$$

33. A heterojunction semi-conductor device in accordance with claim 26, wherein the ratio of the current flowing from the emitter base to the current associated with the surface effect at the emitter base junction is a function of $\Delta E_g$, the difference in band-gap of the materials chosen for the emitter and base is in accordance with the following formula:

$$\frac{I_O}{I_S} \, \alpha \quad \exp\left[\frac{q}{KT} \, [\Delta \, E_g - \Delta \, E_c]\right]$$

FIG.1

FIG.2

FIG.3

FIG.4

FIG.5

FIG.6

FIG.7

$$\beta = \frac{I_c}{I_B}$$

FIG.8

INJECTION CURRENT, $I_c$ CURVE

## FIG.9a

| |
|---|
| EMITTER N |
| BASE P |
| COLLECTOR N |

## FIG.9

## FIG.10

## FIG.11

## FIG.12

## FIG.13

## FIG.14